# FASCICULE DE BREVET EUROPEEN

(11) **EP 3 512 322 B1**
(45) Date de publication et mention de la délivrance du brevet: **05.04.2023**
(21) Numéro de dépôt: 18214839.5
(22) Date de dépôt: 20.12.2018
(51) Int. Cl.: H05K 9/00

(54) **PROCEDE D'ISOLATION D'UN BOITIER DE DISPOSITIF DE CONNEXION ELECTRIQUE VIS-A-VIS DES ONDES ELECTROMAGNETIQUES ET BOITIER OBTENU PAR LA MISE EN OEUVRE DE CE PROCEDE**
ISOLATIONSVERFAHREN EINES GEHÄUSES FÜR ELEKTRISCHE VERBINDUNGSVORRICHTUNG GEGEN ELEKTROMAGNETISCHE WELLEN, UND DURCH ANWENDUNG DIESES VERFAHRENS ERHALTENES GEHÄUSE
METHOD FOR INSULATING A HOUSING FOR ELECTRICAL CONNECTION DEVICE AGAINST ELECTROMAGNETIC WAVES AND HOUSING OBTAINED BY IMPLEMENTING SAID METHOD

(30) Priorité: 16.01.2018 FR 1850359
(43) Date de publication de la demande: 17.07.2019
(73) Titulaire: Amphenol - Air LB, 08110 Carignan (FR)
(72) Inventeur: WANSCHOOR, Anthony, 08200 SEDAN (FR); WAFFLART, Bruno, 08110 PURE (FR); TA, Dang Quang, 08110 BLAGNY (FR)
(74) Mandataire: Cabinet Bleger-Rhein-Poupon

(56) Documents cités:
- WO-A1-02/26010
- GB-A- 2 318 758
- JP-A- S60 132 717

## Description

La présente invention a trait à un procédé d'isolation, vis-à-vis des ondes électromagnétiques, d'un boîtier de dispositif de connexion électrique ainsi qu'à un boîtier de dispositif de connexion électrique obtenu par la mise en oeuvre de ce procédé.

L'invention concerne le domaine de la fabrication des composants électriques, plus particulièrement le domaine de la fabrication des dispositifs de connexion électrique destinés à assurer une connexion électrique d'au moins un câble électrique avec au moins un autre câble électrique, notamment d'au moins une partie des câbles électriques d'au moins un faisceau de câbles électriques chacun avec au moins un autre câble électrique d'au moins un autre faisceau de câbles électriques.

Un tel dispositif de connexion électrique comporte un boîtier qui comporte au moins une cavité destinée à recevoir, chacune, soit au moins un organe de connexion électrique (voire encore au moins un câble électrique associé à un tel organe de connexion électrique), soit au moins un insert recevant ou destiné à recevoir au moins un tel organe de connexion électrique (voire encore au moins un tel câble électrique).

A ce propos, on observera que, à l'intérieur du boîtier, le signal électrique véhiculé par un tel câble électrique peut être sensible aux ondes électromagnétiques, qui sont extérieures au boîtier, et qui sont susceptibles de parasiter ce signal électrique véhiculé et, ainsi, de dégrader la qualité de ce signal électrique véhiculé. A l'inverse, le signal électrique véhiculé par un tel câble électrique peut générer, à l'extérieur du boîtier, des ondes électromagnétiques qui sont susceptibles de parasiter un autre signal électrique extérieur au boîtier, notamment un signal électrique au sein d'un composant électrique extérieur au boîtier.

Afin d'assurer une isolation, vis-à-vis des ondes électromagnétiques, d'un tel boîtier de dispositif de connexion électrique, il est connu de revêtir un tel boîtier avec un revêtement métallique.

Une solution consiste, alors, à rapporter une enveloppe métallique ou métallisée par-dessus ce boîtier de dispositif de connexion électrique. Cette solution implique de concevoir, de fabriquer, de stocker, d'acheminer, d'approvisionner et de mettre en place (voire de fixer), sur le boîtier de dispositif de connexion électrique, une pièce supplémentaire, à savoir l'enveloppe métallique ou métallisée. Outre le fait que cette pièce supplémentaire renchérit le coût global de fabrication du dispositif de connexion électrique, cette enveloppe métallique ou métallisée revêt uniquement une partie du boîtier de dispositif de connexion électrique et n'offre, donc, qu'une isolation réduite vis-à-vis des ondes électromagnétiques.

Une autre solution consiste, d'une part, à métalliser une partie du boîtier de dispositif de connexion électrique en revêtant une partie seulement de la surface extérieure de ce boîtier avec une couche de métal ou d'un alliage métallique et, d'autre part, à préserver des zones de ce boîtier qui ne doivent pas être conductrices, ceci de manière à conserver l'isolation électrique entre les lignes électriques. Pour ce faire, dans le cadre de la fabrication d'un tel boîtier de dispositif de connexion électrique, il est connu d'obturer la cavité ou les cavités (destinées à recevoir au moins un organe de connexion électrique, voire encore au moins un câble électrique associé à un tel organe de connexion, ou un insert recevant ou destiné à recevoir au moins un tel organe de connexion, voire encore au moins un tel câble électrique) de ce boîtier à l'aide d'au moins un obturateur, ceci avant de procéder à la métallisation de ce boîtier. Ceci nécessite, alors, de concevoir, de fabriquer, de stocker, d'acheminer, d'approvisionner, de mettre en place (avant la métallisation) et de retirer (après la métallisation) de tels obturateurs. Outre le fait que ces obturateurs constituent, là encore, des pièces supplémentaires qui renchérissent le coût global de fabrication du dispositif de connexion électrique, la mise en place de ces obturateurs se fait obligatoirement de manière manuelle ce qui allonge la durée de fabrication et complexifie le procédé de fabrication du dispositif de connexion électrique. De plus, on observera que ce ou ces obturateurs ne permettent pas toujours de garantir une obturation appropriée des cavités du boîtier ce qui entraîne, durant la phase de métallisation, des fuites du produit de métallisation et une contamination des zones qui doivent être préservées. Il en découle des défauts de qualité dans les boîtiers et dans les dispositifs qui, de ce fait, sont mis au rebut. Cet inconvénient est amplifié par le fait qu'il est particulièrement difficile de vérifier la qualité de l'obturation réalisée par l'intermédiaire de ce ou de ces obturateurs, ceci lors de la mise en place d'un tel obturateur, avant la métallisation et après la métallisation.

On connait, encore, par le document WO02/26010 un procédé de fabrication de boîtiers pour un blindage électromagnétique. Ces boîtiers ont un corps qui comporte sensiblement un espace intérieur et qui, sur une surface en regard dudit espace, est revêtu d'une couche électriquement conductrice.

Dans le document GB2318758 il est décrit une couche conductrice sensiblement plane qui fournit un écran conducteur. La couche conductrice est formée sous vide pour produire une pièce formée sous vide.

Dans le document JPS60132717 il est décrit un boîtier de protection contre les ondes électromagnétiques pourvu d'une couche non conductrice à l'extérieur d'une couche de protection contre les ondes électromagnétiques. Pour obtenir un tel boîtier de protection on utilise une matrice de moulage de couche de protection contre les ondes électromagnétiques et un moule de moulage de boîtier de protection contre les ondes électromagnétiques.

La présente invention se veut de remédier aux inconvénients des procédés de protection électromagnétique des boîtiers de dispositif de connexion électrique de l'état de la technique ainsi que des boîtiers obtenus par la mise en oeuvre de ces procédés.

A cet effet, l'invention concerne un procédé d'isolation, vis-à-vis des ondes électromagnétiques, d'un boîtier de dispositif de connexion électrique, ce boîtier est réalisé en un matériau isolant électrique et comporte au moins une cavité. Le procédé d'isolation consiste en ce que :
- on obture la ou les cavités du boîtier de dispositif de connexion électrique ;
- on métallisé, ensuite, au moins une partie de la surface extérieure de ce boîtier.

Ce procédé est caractérisé par le fait que :
- on obture la ou les cavités du boîtier de dispositif de connexion électrique en surmoulant un matériau de surmoulage sur ce boîtier ;
- après métallisation, on sépare le matériau de surmoulage et le boîtier de dispositif de connexion électrique.

Une autre caractéristique consiste en ce qu'on surmoule le matériau de surmoulage en injectant ce matériau de surmoulage au moins à l'intérieur de la cavité ou des cavités du boîtier de dispositif de connexion électrique.

Le procédé consiste, encore, en ce qu'on définit des moyens de réception d'un organe de manutention et/ou de maintien du boîtier de dispositif de connexion électrique.

L'invention concerne, également, un boîtier de dispositif de connexion électrique, ce boîtier étant réalisé en un matériau isolant électrique, comportant au moins une cavité, et étant obtenu par la mise en oeuvre du procédé décrit ci-dessus.

L'invention concerne, aussi, un dispositif de connexion électrique comportant un tel boîtier.

Finalement, l'invention concerne un ensemble comportant, d'une part, un boîtier de dispositif de connexion électrique, ce boîtier étant réalisé en un matériau isolant électrique et comportant au moins une cavité et, d'autre part, des moyens d'obturation de la cavité ou des cavités du boîtier, caractérisé par le fait que les moyens d'obturation sont constitués par un matériau de surmoulage, qui est surmoulé sur ce boîtier de dispositif de connexion électrique, et qui s'étend au moins à l'intérieur de la ou des cavités de ce boîtier.

Ainsi, l'invention concerne un procédé d'isolation d'un boîtier de dispositif de connexion électrique, ceci vis-à-vis des ondes électromagnétiques.

Ce procédé consiste, en particulier, en ce qu'on métallise une partie du boîtier de dispositif de connexion électrique ce qui permet, avantageusement, d'éviter de recourir à une enveloppe métallique ou métallisée qui, d'une part, constitue une pièce supplémentaire à un tel boîtier et, donc, à un tel dispositif et, d'autre part, réduit la surface de protection électromagnétique d'un tel boîtier.

Ce procédé consiste, également, en ce que, avant de métalliser une partie du boîtier de dispositif de connexion électrique, on obture la ou les cavités de ce boîtier en surmoulant un matériau de surmoulage sur ce boîtier.

Cette caractéristique permet, avantageusement, d'éviter d'avoir recours à des obturateurs présentant les inconvénients exposés ci-dessus et, en particulier, d'éviter une étape de fabrication consistant à mettre en place, de manière manuelle, de tels obturateurs au niveau de la ou des cavités d'un boîtier de dispositif de connexion électrique ainsi que le coût d'une telle étape de fabrication.

Cette caractéristique permet, également et de manière avantageuse, d'obturer de manière appropriée la ou les cavités du boîtier de dispositif de connexion électrique de sorte que, au cours et après la métallisation de ce boîtier, on évite toute fuite de produit de métallisation et, donc, toute contamination des zones qui doivent être préservées et qui restent donc préservées.

Il en résulte une amélioration de la qualité de fabrication des boîtiers de dispositif de connexion électrique et, donc, une diminution du coût de fabrication de ces boîtiers et, a fortiori, des dispositifs de connexion électrique.

D'autres buts et avantages de la présente invention apparaîtront au cours de la description qui va suivre se rapportant à des modes de réalisation qui ne sont donnés qu'à titre d'exemples indicatifs et non limitatifs.

La compréhension de cette description sera facilitée en se référant aux dessins joints en annexe et dans lesquels :
- la figure 1 est une vue schématisée et en perspective d'un boîtier de dispositif de connexion électrique, ceci avant la mise en oeuvre du procédé d'isolation conforme à l'invention ;
- la figure 2 est une vue schématisée et en perspective du boîtier de dispositif de connexion électrique illustré figure 1, ceci après une première étape du procédé d'isolation de ce boîtier ;
- la figure 3 est une vue similaire aux figures 1 et 2 et correspond au boîtier de dispositif de connexion électrique illustré figures 1 et 2, ceci après une deuxième étape du procédé d'isolation conforme à l'invention ;
- la figure 4 est une vue similaire aux figures 1 à 3 et correspond au boîtier de dispositif de connexion électrique illustré figures 1 à 3, ceci après une troisième étape du procédé d'isolation conforme à l'invention ;
- la figure 5 est une vue similaire aux figures 1 à 4 et illustre un dispositif de connexion électrique comportant, d'une part, un boîtier obtenu par la mise en oeuvre du procédé d'isolation conforme à l'invention, et, d'autre part, un insert destiné à recevoir au moins une partie des moyens permettant d'assurer une connexion électrique.

La présente invention concerne le domaine de la fabrication des dispositifs de connexion électrique destinés à assurer une connexion électrique d'au moins un câble électrique avec au moins un autre câble électrique, notamment d'au moins une partie des câbles électriques d'au moins un faisceau de câbles électriques chacun avec au moins un autre câble électrique d'au moins un autre faisceau de câbles électriques.

Un tel dispositif de connexion électrique 1 comporte un boîtier 2, qui est réalisé en un matériau isolant électrique, et qui présente une surface intérieure orientée vers l'intérieur de ce boîtier 2 et, d'autre part, une surface extérieure orientée vers l'extérieur de ce boîtier 2.

Ce boîtier 2 comporte des parois 3, notamment une paroi de fond 30 (constituant le fond de ce boîtier 2), des parois longitudinales 31 (s'étendant à partir de la paroi de fond 30) et au moins une paroi latérale 32 (s'étendant à partir de la paroi de fond 30, à partir des parois longitudinales 31, et raccordant ces parois longitudinales 31).

Ces parois (3, 30, 31, 32) présentent, chacune, d'une part, une surface intérieure orientée vers l'intérieur du boîtier 2 et, d'autre part, une surface extérieure orientée vers l'extérieur de ce boîtier 2.

Un tel boîtier 2 comporte, également, au moins une cavité (4 ; 5).

En particulier, un tel boîtier 2 peut comporter au moins une cavité interne 4 délimitée au moins par la paroi de fond 30, par les parois longitudinales 31, ainsi que par la paroi latérale 32 ou par au moins une des parois latérales 32.

Un tel boîtier 2 peut, aussi, comporter au moins une cavité traversante 5, que comporte la paroi latérale 32 ou au moins une des parois latérales 32, et qui traverse une telle paroi latérale 32 ou de telles parois latérales 32.

Un tel boîtier 2 comporte, encore, un revêtement métallique 6 qui s'étend sur au moins une partie de la surface extérieure du boîtier 2, notamment sur au moins une partie de la surface extérieure d'au moins une partie des parois (3, 30, 31, 32) de ce boîtier 2, plus particulièrement sur au moins une partie de la surface extérieure de la paroi de fond 30 et des parois longitudinales 31, de préférence sur l'intégralité de la surface extérieure de cette paroi de fond 30 et de ces parois longitudinales 31.

Un tel revêtement métallique 6 est constitué par une couche de métal ou d'un alliage contenant du métal, une telle couche recouvrant ladite au moins une partie de la surface extérieure du boîtier 2.

Un tel revêtement métallique 6 constitue une zone conductrice électrique et permet de réaliser une isolation (plus particulièrement électrique) du boîtier 2, ceci vis-à-vis des ondes électromagnétiques.

A ce propos, on observera que ce revêtement métallique 6 permet de réaliser une isolation du boîtier 2 vis-à-vis des ondes électromagnétiques extérieures au boîtier 2, ceci de manière à préserver la qualité d'un signal électrique véhiculé à l'intérieur de ce boîtier 2. Ce revêtement métallique 6 permet, également, de réaliser une isolation du boîtier 2 vis-à-vis des ondes électromagnétiques intérieures à ce boîtier 2, ceci de manière à préserver la qualité d'un signal électrique au sein d'un composant électrique extérieur au boîtier 2.

Une autre caractéristique consiste en ce que ledit dispositif de connexion électrique 1 peut, également, comporter au moins un moyen de connexion électrique configuré pour assurer une connexion électrique d'au moins un câble électrique (associé à ce dispositif de connexion électrique 1 et à un tel moyen de connexion électrique) avec au moins un autre câble électrique (notamment associé à ce dispositif de connexion électrique 1 ou à un autre dispositif de connexion électrique). De tels moyens de connexion électrique peuvent être configurés pour assurer la connexion électrique d'au moins une partie des câbles électriques d'au moins un faisceau de câbles électriques (associé à ce dispositif de connexion électrique 1) chacun avec au moins un autre câble électrique d'au moins un autre faisceau de câbles électriques (notamment associé à ce dispositif de connexion électrique 1 ou à un autre dispositif de connexion électrique).

De manière alternative ou additionnelle, un tel dispositif de connexion électrique 1 peut comporter au moins un moyen de réception 7 configuré pour recevoir au moins un tel moyen de connexion électrique et/ou au moins un câble électrique (notamment associés à un tel moyen de connexion électrique) dont il convient d'assurer une connexion électrique.

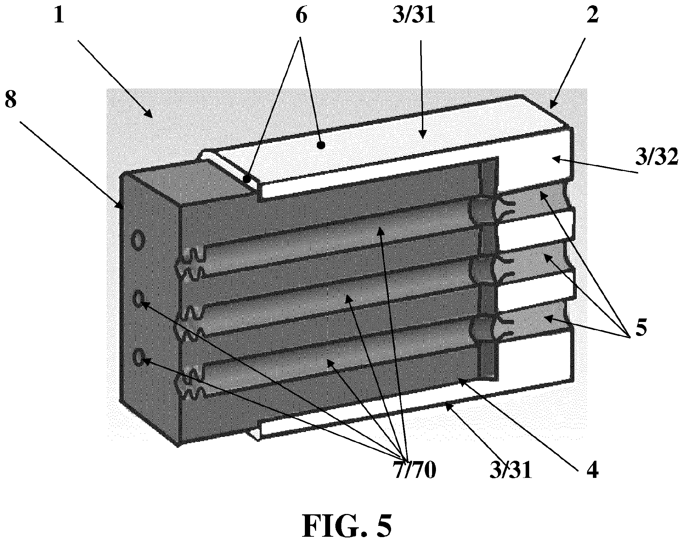

Selon un mode particulier de réalisation illustré figure 5, un tel dispositif de connexion électrique 1 peut, encore, comporter un insert 8, positionné au moins à l'intérieur de la cavité interne 4 du boîtier 2 (voire encore à l'intérieur de la cavité traversante 5 ou d'au moins l'une des cavités traversantes 5 de ce boîtier 2), et comportant au moins un tel moyen de réception 7.

A ce propos, on observera qu'un tel insert 8 peut, alors, être surmoulé sur le boîtier 2, plus particulièrement à l'intérieur de ce boîtier 2, notamment au moins à l'intérieur de la cavité interne 4 de ce boîtier 2 (voire encore à l'intérieur de la cavité traversante 5 ou d'au moins l'une des cavités traversantes 5 de ce boîtier 2).

En ce qui concerne ledit moyen de réception 7, celui-ci peut être constitué par au moins un orifice 70, traversant ledit insert 8, et débouchant au regard de l'une des cavités traversantes 5 du boîtier 2.

Un tel orifice 70 peut, alors, être conçu pour recevoir au moins un câble électrique (non représenté), voire encore au moins un moyen de connexion (non représenté) associé à un tel câble électrique.

L'invention concerne, également, un procédé d'isolation, vis-à-vis des ondes électromagnétiques, d'un boîtier 2 de dispositif de connexion électrique 1.

Un tel boîtier 2 présente au moins une partie (voire, et de préférence, l'intégralité) des caractéristiques décrites ci-dessus, notamment le fait qu'il soit réalisé en un matériau isolant électrique et comporte au moins une cavité (4 ; 5).

Ce procédé d'isolation consiste en ce que :
- on obture la ou les cavités (4 ; 5) du boîtier 2 de dispositif de connexion électrique 1 ;
- on métallise, ensuite, au moins une partie de la surface extérieure de ce boîtier 2.

En fait, ce procédé d'isolation consiste en ce que :
- on obture la ou les cavités (4 ; 5) du boîtier 2 de dispositif de connexion électrique 1 en surmoulant un matériau de surmoulage sur ce boîtier 2 ;
- après métallisation, on sépare le matériau de surmoulage et le boîtier 2 de dispositif de connexion électrique 1.

A ce propos, on observera qu'on surmoule le matériau de surmoulage en injectant ce matériau de surmoulage au moins à l'intérieur (voire, et de préférence, au travers) de la cavité (4 ; 5) ou des cavités (4 ; 5) du boîtier 2 de dispositif de connexion électrique 1.

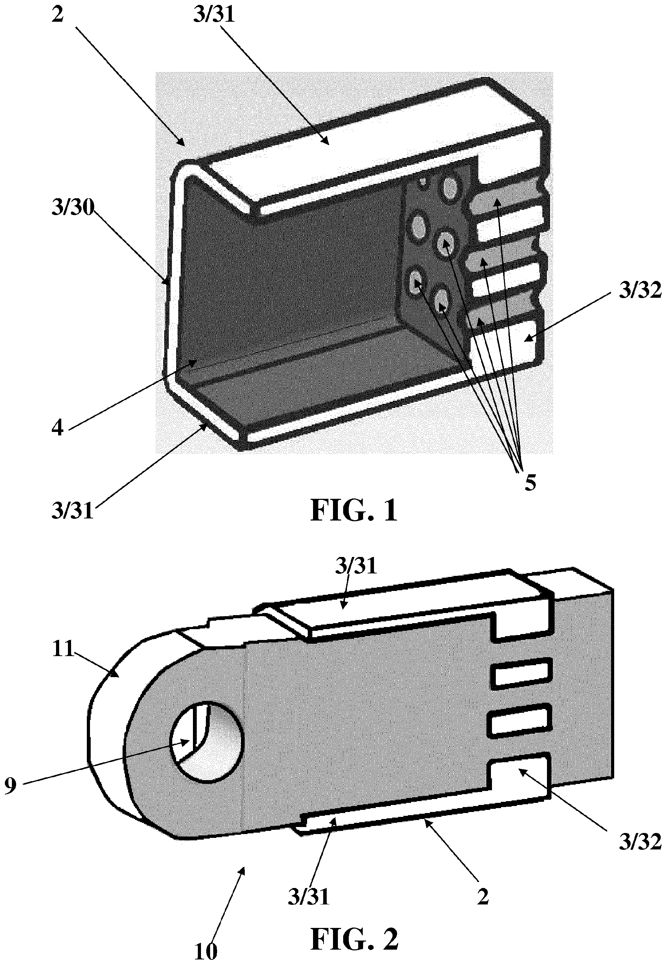

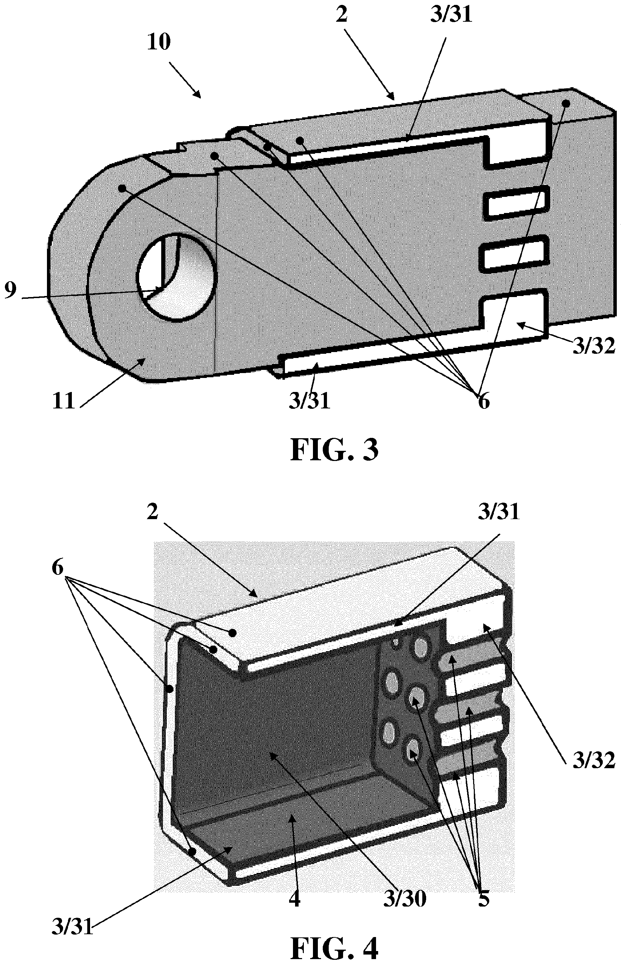

Plus particulièrement, on injecte ce matériau de surmoulage à l'intérieur de la cavité interne 4 de ce boîtier 2 ainsi qu'à l'intérieur de la cavité traversante 5 ou d'au moins l'une des cavités traversantes 5 de ce boîtier 2, notamment de l'ensemble des cavités traversantes 5 de ce boîtier 2. Un mode préféré de réalisation illustré figures 2 et 3 consiste en ce qu'on injecte ce matériau de surmoulage à l'intérieur de la cavité interne 4 de ce boîtier 2 ainsi qu'au travers de la cavité traversante 5 ou d'au moins l'une des cavités traversantes 5 de ce boîtier 2, notamment de l'ensemble des cavités traversantes 5 de ce boîtier 2.

Selon une autre caractéristique, le matériau de surmoulage est une silicone.

Tel que mentionné ci-dessus, on métallisé au moins une partie de la surface extérieure du boîtier 2 de dispositif de connexion électrique 1.

A ce propos, on observera qu'on métallise au moins une partie de la surface extérieure d'au moins une partie des parois (3, 30, 31, 32) de ce boîtier 2, plus particulièrement au moins une partie de la surface extérieure de la paroi de fond 30 et des parois longitudinales 31, de préférence l'intégralité de la surface extérieure de cette paroi de fond 30 et de ces parois longitudinales 31.

En fait, le procédé consiste, également, en ce que l'on métallise au moins une partie de la surface extérieure du matériau de surmoulage (figure 3).

De plus, on métallise en revêtant (plus particulièrement en recouvrant) cette partie ou ces parties de la surface extérieure du boîtier 2 (voire encore au moins une partie de la surface extérieure du matériau de surmoulage) avec une couche de métal ou d'un alliage contenant du métal.

Cette métallisation permet, en particulier, de définir le revêtement métallique 6 décrit ci-dessus.

Une autre caractéristique du procédé d'isolation consiste en ce qu'on définit des moyens de réception 9 d'un organe de manutention et/ou de maintien du boîtier 2 de dispositif de connexion électrique 1.

En fait, on définit les moyens de réception 9 lorsqu'on surmoule le matériau de surmoulage sur le boîtier 2 de dispositif de connexion électrique 1.

Le procédé d'isolation consiste, encore, en ce que, après métallisation, on sépare le matériau de surmoulage et le boîtier 2 de dispositif de connexion électrique 1, ceci en découpant ce matériau de surmoulage, plus particulièrement en découpant la silicone de surmoulage.

L'invention concerne, alors, également, un boîtier 2 de dispositif de connexion électrique 1.

Ce boîtier 2 présente au moins une partie (voire, et de préférence, l'intégralité) des caractéristiques décrites ci-dessus.

En particulier, ce boîtier 2 est réalisé en un matériau isolant électrique et comporte au moins une cavité (4 ; 5).

Plus particulièrement, ce boîtier 2 est obtenu par la mise en oeuvre du procédé d'isolation décrit ci-dessus.

L'invention concerne, aussi, un dispositif de connexion électrique 1 qui présente au moins une partie (voire, et de préférence, l'intégralité) des caractéristiques décrites ci-dessus.

En particulier, ce dispositif de connexion électrique 1 comporte un boîtier 2, qui est réalisé en un matériau isolant électrique, qui comporte au moins une cavité (4 ; 5), et qui est obtenu par la mise en oeuvre du procédé d'isolation décrit ci-dessus.

Un tel dispositif de connexion électrique 1 comporte, encore, au moins un insert 8 qui présente les caractéristiques décrites ci-dessus.

En particulier, un tel insert 8 comporte au moins un moyen de réception 7 configuré pour recevoir au moins un moyen de connexion électrique et/ou au moins un câble électrique (notamment associé à un tel moyen de connexion électrique) dont il convient d'assurer une connexion électrique.

Un tel insert 8 s'étend au moins à l'intérieur d'au moins un des cavités (4 ; 5) du boîtier 2, plus particulièrement au moins à l'intérieur de la cavité interne 4 de ce boîtier 2.

L'invention concerne, également, un ensemble 10 comportant, d'une part, un boîtier 2 de dispositif de connexion électrique 1. Ce boîtier 2 présente au moins une partie (voire, et de préférence, l'intégralité) des caractéristiques décrites ci-dessus, en particulier le fait qu'il soit réalisé en un matériau isolant électrique et qu'il comporte au moins une cavité (4 ; 5) .

D'autre part, cet ensemble 10 comporte des moyens d'obturation 11 de la cavité (4 ; 5) ou des cavités (4 ; 5) du boîtier 2, ces moyens d'obturation 11 étant constitués par un matériau de surmoulage, qui est surmoulé sur ce boîtier 2 de dispositif de connexion électrique 1, et qui s'étend au moins à l'intérieur (voire au travers) de la ou des cavités (4 ; 5) de ce boîtier 2.

Dans cet ensemble 10, le matériau de surmoulage est une silicone.

Un tel ensemble 10 est obtenu après la mise en oeuvre d'au moins une partie des étapes du procédé d'isolation mentionné ci-dessus, notamment après la mise en oeuvre d'une étape de surmoulage du matériau de surmoulage sur le boîtier 2. Un tel ensemble 10 a été illustré figure 2.

Cet ensemble 10 comporte, encore, un revêtement métallique 6 qui s'étend sur au moins une partie de la surface extérieure du boîtier 2 et/ou sur au moins une partie de la surface extérieure des moyens d'obturation 11.

En fait, un tel ensemble 10 est obtenu après la mise en oeuvre d'au moins une partie des étapes du procédé d'isolation mentionné ci-dessus, notamment après la mise en oeuvre d'une étape de métallisation d'au moins une partie du boîtier 2 et d'au moins une partie des moyens d'obturation 11.

Un tel ensemble 10 a été illustré figure 3.

En ce qui concerne ce revêtement métallique 6, celui-ci s'étend sur au moins une partie de la surface extérieure du boîtier 2 et constitue, alors, des moyens d'isolation de ce boîtier 2 vis-à-vis des ondes électromagnétiques.

Ce revêtement métallique 6 présente les caractéristiques décrites ci-dessus. En particulier, ce revêtement métallique 6 est constitué par une couche de métal ou d'un alliage contenant du métal. Ce revêtement métallique 6 revêt au moins une partie de la surface extérieure du boîtier 2 et a été déposé par métallisation conformément à une étape du procédé d'isolation mentionné ci-dessus.

De manière additionnelle, cet ensemble 10 peut, encore, comporter les moyens de réception 9 d'un organe de manutention et/ou de maintien du boîtier 2 de dispositif de connexion électrique 1. Ce sont, plus particulièrement, les moyens d'obturation 11 qui comportent de tels moyens de réception 9.

## Revendications

1. Procédé d'isolation, vis-à-vis des ondes électromagnétiques, d'un boîtier (2) de dispositif de connexion électrique (1), ce boîtier (2) est réalisé en un matériau isolant électrique et comporte au moins une cavité (4 ; 5) tandis que le procédé d'isolation consiste en ce que :
- on obture la ou les cavités (4 ; 5) du boîtier (2) de dispositif de connexion électrique (1) ;
- on métallisé, ensuite, au moins une partie de la surface extérieure de ce boîtier (2) ;
- **caractérisé par le fait que** :
- on obture la ou les cavités (4 ; 5) du boîtier (2) de dispositif de connexion électrique (1) en surmoulant un matériau de surmoulage sur ce boîtier (2) ;
- après métallisation, on sépare le matériau de surmoulage et le boîtier (2) de dispositif de connexion électrique (1).

2. Procédé d'isolation selon la revendication 1, **caractérisé par le fait qu'**on surmoule le matériau de surmoulage en injectant ce matériau de surmoulage au moins à l'intérieur de la cavité (4 ; 5) ou des cavités (4 ; 5) du boîtier (2) de dispositif de connexion électrique (1).

3. Procédé d'isolation selon l'une quelconque des revendications 1 ou 2, **caractérisé par le fait que** le matériau de surmoulage est une silicone.

4. Procédé d'isolation selon l'une quelconque des revendications précédentes, **caractérisé par le fait qu'**on métallisé au moins une partie de la surface extérieure du boîtier (2) de dispositif de connexion électrique (1) en revêtant cette partie ou ces parties de la surface extérieure avec une couche de métal ou d'un alliage contenant du métal.

5. Procédé d'isolation selon l'une quelconque des revendications précédentes, **caractérisé par le fait qu'**on définit des moyens de réception (9) d'un organe de manutention et/ou de maintien du boîtier (2) de dispositif de connexion électrique (1).

6. Procédé d'isolation selon la revendication 5, **caractérisé par le fait qu'**on définit les moyens de réception (9) lorsqu'on surmoule le matériau de surmoulage sur le boîtier (2) de dispositif de connexion électrique (1).

7. Procédé d'isolation selon l'une quelconque des revendications précédentes, **caractérisé par le fait qu'**on sépare le matériau de surmoulage et le boîtier (2) de dispositif de connexion électrique (1) en découpant ce matériau de surmoulage.

8. Ensemble (10) comportant, d'une part, un boîtier (2) de dispositif de connexion électrique (1), ce boîtier (2) étant réalisé en un matériau isolant électrique et comportant au moins une cavité (4 ; 5) et, d'autre part, des moyens d'obturation (11) de la cavité (4 ; 5) ou des cavités (4 ; 5) du boîtier (2), **caractérisé par le fait que** les moyens d'obturation (11) sont constitués par un matériau de surmoulage, qui est surmoulé sur ce boîtier (2) de dispositif de connexion électrique (1), et qui s'étend au moins à l'intérieur de la ou des cavités (4 ; 5) de ce boîtier (2).

9. Ensemble (10) selon la revendication 8, **caractérisé par le fait que** le matériau de surmoulage est une silicone.

10. Ensemble (10) selon l'une quelconque des revendications 8 ou 9, **caractérisé par le fait qu'**il comporte un revêtement métallique (6) qui s'étend sur au moins une partie de la surface extérieure du boîtier (2) et/ou sur au moins une partie de la surface extérieure des moyens d'obturation (11).

11. Ensemble (10) selon la revendication 10, **caractérisé par le fait que** le revêtement métallique (6) est constitué par une couche de métal ou d'un alliage contenant du métal.

12. Ensemble (10) selon l'une quelconque des revendications 8 à 11, **caractérisé par le fait qu'**il comporte des moyens de réception (9) d'un organe de manutention et/ou de maintien du boîtier de connexion électrique.

## Patentansprüche

1. Verfahren zum Isolieren eines Gehäuses (2) für eine elektrische Verbindungsvorrichtung (1) gegenüber elektromagnetischen Wellen, wobei dieses Gehäuse (2) aus einem elektrisch isolierenden Material hergestellt ist und mindestens einen Hohlraum (4; 5) umfasst, während das Isolationsverfahren besteht aus:
- Verschließen des oder der Hohlraums/Hohlräume (4; 5) des Gehäuses (2) für die elektrische Verbindungsvorrichtung (1);
- anschließendes Metallisieren mindestens eines Teils der Außenoberfläche dieses Gehäuses (2);
- **gekennzeichnet durch:**
- Verschließen des oder der Hohlraums/Hohlräume (4; 5) des Gehäuses (2) für die elektrische Verbindungsvorrichtung (1) durch Spritzen eines Umspritzungsmaterials auf dieses Gehäuse (2);
- Trennen des Umspritzungsmaterials und des Gehäuses (2) für die elektrische Verbindungsvorrichtung (1) nach dem Metallisieren.

2. Isolationsverfahren nach Anspruch 1, **dadurch gekennzeichnet, dass** das Umspritzungsmaterial durch Einspritzen dieses Umspritzungsmaterials mindestens in das Innere des Hohlraums (4; 5) oder der Hohlräume (4; 5) des Gehäuses (2) für die elektrische Verbindungsvorrichtung (1) gespritzt wird.

3. Isolationsverfahren nach einem der Ansprüche 1 oder 2,
**dadurch gekennzeichnet, dass** das Umspritzungsmaterial ein Silikon ist.

4. Isolationsverfahren nach einem der vorstehenden Ansprüche,
**dadurch gekennzeichnet, dass** mindestens ein Teil der Außenoberfläche des Gehäuses (2) für die elektrische Verbindungsvorrichtung (1) durch Beschichten dieses Teils oder dieser Teile der Außenoberfläche mit einer Schicht aus Metall oder einer metallhaltigen Legierung metallisiert wird.

5. Isolationsverfahren nach einem der vorstehenden Ansprüche,
**dadurch gekennzeichnet, dass** Mittel (9) zum Aufnehmen einer Einrichtung zum Handhaben und/oder zum Halten des Gehäuses (2) für die elektrische Verbindungsvorrichtung (1) definiert werden.

6. Isolationsverfahren nach Anspruch 5, **dadurch gekennzeichnet, dass** die Mittel (9) zum Aufnehmen definiert werden, wenn das Umspritzungsmaterial auf das Gehäuse (2) für die elektrische Verbindungsvorrichtung (1) gespritzt wird.

7. Isolationsverfahren nach einem der vorstehenden Ansprüche,
**dadurch gekennzeichnet, dass** das Umspritzungsmaterial und das Gehäuse (2) für die elektrische Verbindungsvorrichtung (1) durch Schneiden dieses Umspritzungsmaterials voneinander getrennt werden.

8. Baugruppe (10), umfassend einerseits ein Gehäuse (2) für die elektrische Verbindungsvorrichtung (1), wobei dieses Gehäuse (2) aus einem elektrisch isolierenden Material hergestellt ist und mindestens einen Hohlraum (4; 5) umfasst, und andererseits Mittel zum Verschließen (11) des Hohlraums (4; 5) oder der Hohlräume (4; 5) des Gehäuses (2), **dadurch gekennzeichnet, dass** die Mittel zum Verschließen (11) aus einem Umspritzungsmaterial bestehen, das auf dieses Gehäuse (2) für die elektrische Verbindungsvorrichtung (1) gespritzt wird und das sich mindestens in das Innere des Hohlraums oder der Hohlräume (4; 5) dieses Gehäuses (2) erstreckt.

9. Baugruppe (10) nach Anspruch 8, **dadurch gekennzeichnet, dass** das Umspritzungsmaterial ein Silikon ist.

10. Baugruppe (10) nach einem der Ansprüche 8 oder 9,
**dadurch gekennzeichnet, dass** sie eine Metallbeschichtung (6) umfasst, die sich auf mindestens einem Teil der Außenoberfläche des Gehäuses (2) und/oder auf mindestens einem Teil der Außenoberfläche der Mittel zum Verschließen (11) erstreckt.

11. Baugruppe (10) nach Anspruch 10, **dadurch gekennzeichnet, dass** die Metallbeschichtung (6) aus einer Schicht aus Metall oder einer metallhaltigen Legierung besteht.

12. Baugruppe (10) nach einem der Ansprüche 8 bis 11,
**dadurch gekennzeichnet, dass** sie Mittel zum Aufnehmen (9) einer Einrichtung zum Handhaben und/oder zum Halten des Gehäuses für eine elektrische Verbindung umfasst.

## Claims

1. Method for insulating, from electromagnetic waves, a housing (2) of an electrical connection device (1), this housing (2) being made of an electrically insulating material and comprising at least one cavity (4; 5), and the insulation method consisting in the following:
- sealing the cavity or cavities (4; 5) of the housing (2) of the electrical connection device (1);
- subsequently metallizing at least part of the exterior surface of this housing (2);
- **characterized in that:**
- the cavity or cavities (4; 5) of the housing (2) of the electrical connection device (1) is or are sealed by overmolding an overmolding material onto this housing (2);
- after metallization, the overmolding material and the housing (2) of the electrical connection device (1) are separated.

2. Insulation method according to claim 1, **characterized in that** the overmolding material is overmolded by injecting this overmolding material at least inside the cavity (4; 5) or cavities (4; 5) of the housing (2) of the electrical connection device (1).

3. Insulation method according to either claim 1 or claim 2, **characterized in that** the overmolding material is a silicone.

4. Insulation method according to any of the preceding claims, **characterized in that** at least part of the outer surface of the housing (2) of the electrical connection device (1) is metallized by coating this part or these parts of the outer surface with a layer of metal or metal-containing alloy.

5. Insulation method according to any of the preceding claims, **characterized in that** means (9) for receiving a member for handling and/or holding the housing (2) of the electrical connection device (1) are defined.

6. Insulation method according to claim 5, **characterized in that** the receiving means (9) are defined when the overmolding material is overmolded onto the housing (2) of the electrical connection device (1).

7. Insulation method according to any of the preceding claims, **characterized in that** the overmolding material and the housing (2) of the electrical connection device (1) are separated by cutting this overmolding material.

8. Assembly (10) comprising, on the one hand, a housing (2) of an electrical connection device (1), this housing (2) being made of an electrically insulating material and comprising at least one cavity (4; 5) and, on the other hand, means (11) for sealing the cavity (4; 5) or cavities (4; 5) of the housing (2), **characterized in that** the sealing means (11) are formed by an overmolding material, which is overmolded onto this housing (2) of the electrical connection device (1), and which extends at least inside the cavity or cavities (4; 5) of this housing (2).

9. Assembly (10) according to claim 8, **characterized in that** the overmolding material is a silicone.

10. Assembly (10) according to either claim 8 or claim 9, **characterized in that it** comprises a metal coating (6) which extends over at least part of the outer surface of the housing (2) and/or over at least part of the outer surface of the sealing means (11).

11. Assembly (10) according to claim 10, **characterized in that** the metal coating (6) is formed by a layer of metal or metal-containing alloy.

12. Assembly (10) according to any of claims 8 to 11, **characterized in that it** comprises means (9) for receiving a member for handling and/or holding the electrical connection housing.
